(19) Europäisches Patentamt

European Patent Office

Office européen des brevets

(11) **EP 3 208 678 B1**

(12) **EUROPEAN PATENT SPECIFICATION**

(45) Date of publication and mention
of the grant of the patent:
**07.08.2019 Bulletin 2019/32**

(51) Int Cl.:
***G05B 23/02*** *(2006.01)*     ***G05B 13/04*** *(2006.01)*
***G05B 17/02*** *(2006.01)*     ***G06F 17/50*** *(2006.01)*

(21) Application number: **17157091.4**

(22) Date of filing: **21.02.2017**

(54) **METHOD FOR DETERMINING AIRCRAFT SENSOR FAILURE WITHOUT A REDUNDANT SENSOR AND CORRECT SENSOR MEASUREMENT WHEN REDUNDANT AIRCRAFT SENSORS GIVE INCONSISTENT READINGS**

VERFAHREN ZUR FEHLERBESTIMMUNG IN EINEM FLUGZEUGSENSOR OHNE REDUNDANTEN SENSOREN SOWIE ANGEPASSTE SENSORMESSUNGEN FALLS REDUNDANTEN SENSOREN UNSTIMMIGEN DATEN LIEFERN

MÉTHODE POUR DÉTERMINER UNE ERREUR DE CAPTEUR DANS UN AÉRONEF SANS CAPTEUR REDONDANT ET MESURE D'UN CAPTEUR ADAPTÉE LORSQUE DES CAPTEURS REDONDANTS DÉLIVRENT DES VALEURS INCONSISTANTES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.02.2016 US 201615049562**

(43) Date of publication of application:
**23.08.2017 Bulletin 2017/34**

(73) Proprietor: **Hamilton Sundstrand Corporation Charlotte, NC 28217 (US)**

(72) Inventors:
• **HAGGERTY, Nathan**
 **Avon, CT 06001 (US)**
• **HO, Tony**
 **Glastonbury, CT 06033 (US)**

(74) Representative: **Dehns**
 **St. Bride's House**
 **10 Salisbury Square**
 **London EC4Y 8JD (GB)**

(56) References cited:
**EP-A1- 1 790 838**     **EP-A1- 2 388 672**
**EP-A2- 1 213 562**     **US-A1- 2005 222 747**
**US-A1- 2014 090 456**     **US-A1- 2015 322 789**

• **LU YUNJIA ET AL: "Data-driven model reduction and fault diagnosis for an aero gas turbine engine", 2014 9TH IEEE CONFERENCE ON INDUSTRIAL ELECTRONICS AND APPLICATIONS, IEEE, 9 June 2014 (2014-06-09), pages 1936-1941, XP032665680, DOI: 10.1109/ICIEA.2014.6931485 [retrieved on 2014-10-20]**

EP 3 208 678 B1

## Description

BACKGROUND

The subject matter disclosed herein generally relates to sensor monitoring and, more particularly, to determining sensor failure or correcting sensor measurements among redundant sensors.

Many aircraft systems include many sensors that are used for system controls and protective logic. Some of these sensors are not redundant and therefore, when a sensor drifts away from its calibration, or has failed without an explicit warning, it is often difficult to detect. Further, even with redundant sensors, when one of these two sensors drifts and an inconsistent measurement is given between the redundant sensors, it is difficult to detect which of the two sensors has drifted. As a result, the control system often uses the more conservative of the two readings which often reduces system performance and efficiency.

Sensor drift is often observed in development testing. Also because many sensors are used to protectively shut down or limit system hardware temperatures/pressures to prevent damage, if a sensor reads incorrectly, the system logic cannot properly control the system and hardware damage may occur.
EP 2388672 discloses a method of partitioning turbomachine faults in a computer model. US 2015/0322789 discloses a system, method and program for monitoring a life of a gas turbine engine. LU YUNJIA ET AL: "Data-driven model reduction and fault diagnosis for an aero gas turbine engine", 2014 9TH IEEE CONFERENCE ON INDUSTRIAL ELECTRONICS AND APPLICATIONS, IEEE, June 9 2014, pages 1936-1941, discloses a fault detection fitter for a gas turbine engine system.

Accordingly, there exists a need to provide a better way of monitoring one or more sensors for failure and drift.

BRIEF DESCRIPTION

According to one embodiment a computer implemented method to determine aircraft sensor failure and correct aircraft sensor measurement in an aircraft system is provided. The computer implemented method includes determining, using a physics-based high-fidelity model, a high-fidelity system response over selected operating conditions of a sensor of interest, creating, using an aircraft system controller, a reduced order model (ROM) using the high-fidelity system response, wherein the ROM correlates with the sensor of interest when operating normally, calculating, using the ROM, at least one reduced order sensor value, determining an error value between the reduced order sensor value and a sensor measurement reading from the sensor of interest, and comparing the error value to an error threshold, wherein the sensor of interest has failed when the error value is greater than the error threshold.

In addition to one or more of the features described above, or as an alternative, further embodiments of the computer implemented method may include generating a maintenance message based on the error value, storing the maintenance message in a computer readable storage medium in the aircraft system controller, and transmitting the maintenance message from the aircraft system controller.

In addition to one or more of the features described above, or as an alternative, further embodiments of the computer implemented method may include generating a notification based on the maintenance message, and transmitting the notification to a display visible at the flight deck by service crew, wherein the notification identifies the sensor of interest and notifies that the sensor of interest has failed or drifted and provides a replacement recommendation.

In addition to one or more of the features described above, or as an alternative, further embodiments of the computer implemented method may include generating, in the aircraft system controller, corrective control signals to protect the aircraft system based on the error value, and transmitting the corrective control signals to one or more components of the aircraft system.

In addition to one or more of the features described above, or as an alternative, further embodiments of the computer implemented method may include wherein creating the ROM includes selecting, from a high-fidelity set of parameters, a sub-set of parameters with high correlation to the sensor of interest, wherein the sub-set of parameters have corresponding sensors in the aircraft system such that measurements from the sensors are used to generate the reduced order sensor value.

In addition to one or more of the features described above, or as an alternative, further embodiments of the computer implemented method may include, wherein creating the ROM further includes determining ROM regression coefficients of the ROM.

In addition to one or more of the features described above, or as an alternative, further embodiments of the computer implemented method may include, wherein the sub-set of parameters of the ROM includes one or more of system pressures, system temperatures, valve positions, control references, characteristics related to ambient environment, and characteristics related to aircraft operation.

In addition to one or more of the features described above, or as an alternative, further embodiments of the computer implemented method may include determining, using the ROM, a reduced order system response that includes one or more reduced order sensor values, and determining an aggregate error response between the reduced order system response and a plurality of sensor measurement readings from the sensor of interest.

In addition to one or more of the features described above, or as an alternative, further embodiments of the computer implemented method may include controlling the aircraft system using the calculated reduced order sensor value in response to the sensor of interest failing.

According to another embodiment a reduced order model (ROM) sensor system to determine aircraft sensor failure and correct aircraft sensor measurement in an aircraft system is provided. The ROM sensor system includes a plurality of sensors that include a sensor of interest, a memory having computer readable instructions, and a processor in an aircraft system controller configured to execute the computer readable instructions, the computer readable instructions include determining, using a physics-based high-fidelity model, a high-fidelity system response over selected operating conditions for the sensor of interest, creating, using the aircraft system controller, a reduced order model (ROM) using the high-fidelity system response, wherein the ROM correlates with the sensor of interest when operating normally, calculating, using the ROM, at least one reduced order sensor value, determining an error value between the reduced order sensor value and a sensor measurement reading from the sensor of interest, and comparing the error

value to an error threshold, wherein the sensor of interest has failed when the error value is greater than the error threshold.

In addition to one or more of the features described above, or as an alternative, further embodiments of the ROM sensor system may include additional computer readable instructions include generating a maintenance message based on the error value, storing the maintenance message in a computer readable storage medium in the aircraft system controller, and transmitting the maintenance message from the aircraft system controller.

In addition to one or more of the features described above, or as an alternative, further embodiments of the ROM sensor system may include additional computer readable instructions include generating a notification based on the maintenance message, and transmitting the notification to a display visible at the flight deck by service crew, wherein the notification identifies the sensor of interest and notifies that the sensor of interest has failed or drifted and provides a replacement recommendation.

In addition to one or more of the features described above, or as an alternative, further embodiments of the ROM sensor system may include additional computer readable instructions include generating, in the aircraft system controller, corrective control signals to protect the aircraft system based on the error value, and transmitting the corrective control signals to one or more components of the aircraft system.

In addition to one or more of the features described above, or as an alternative, further embodiments of the ROM sensor system may include, wherein creating the ROM includes selecting, from a high-fidelity set of parameters, a sub-set of parameters with high correlation to the sensor of interest, wherein the sub-set of parameters have corresponding sensors in the aircraft system such that measurements from the sensors are used to generate the reduced order sensor value.

In addition to one or more of the features described above, or as an alternative, further embodiments of the ROM sensor system may include, wherein creating the ROM further includes determining the ROM regression coefficients.

In addition to one or more of the features described above, or as an alternative, further embodiments of the ROM sensor system may include, wherein the subset of parameters of the ROM includes one or more of system pressures, system temperatures, valve positions, control references, characteristics related to ambient environment, and characteristics related to aircraft operation.

In addition to one or more of the features described above, or as an alternative, further embodiments of the ROM sensor system may include additional computer readable instructions include determining, using the ROM, a reduced order system response that includes one or more reduced order sensor values, and determining an aggregate error response between the reduced order system response and a plurality of sensor measurement readings from the sensor of interest.

In addition to one or more of the features described above, or as an alternative, further embodiments of the ROM sensor system may include an additional computer readable instruction include controlling the aircraft system using the calculated reduced order sensor value in response to the sensor of interest failing.

According to one embodiment a computer program product to determine aircraft sensor failure and correct aircraft sensor measurement in an aircraft system is provided. The computer program product includes a computer readable storage medium having program instructions embodied therewith. The program instructions executable by a processor to cause the processor to determine, using a physics-based high-fidelity model, a high-fidelity system response over selected operating conditions for a sensor of interest, create, using an aircraft system controller, a reduced order model (ROM) using the high-fidelity system response, wherein the ROM correlates with the sensor of interest when operating normally, calculate, using the ROM, at least one reduced order sensor value, determine an error value between the reduced order sensor value and a sensor measurement reading from the sensor of interest, and compare the error value to an error threshold, wherein the sensor of interest has failed when the error value is greater than the error threshold.

In addition to one or more of the features described above, or as an alternative, further embodiments of the computer program product may include, having additional program instructions embodied therewith, the additional program instructions executable by the processor to cause the processor to select, from a high-fidelity set of parameters, a sub-set of parameters with high correlation to the sensor of interest, wherein the sub-set of parameters have corresponding sensors in the aircraft system such that measurements from the sensors are used to generate the reduced order sensor value, and determine ROM regression coefficients of the ROM.

The foregoing features and elements may be combined in various combinations without exclusivity, unless expressly indicated otherwise. These features and elements as well as the operation thereof will become more apparent in light of the following description and the accompanying drawings. It should be understood, however, that the following description and drawings are intended to be illustrative and explanatory in nature and non-limiting.

BRIEF DESCRIPTION OF THE DRAWINGS

The foregoing and other features, and advantages of the present disclosure are apparent from the following detailed description taken in conjunction with the accompanying drawings in which:

> FIG. 1 illustrates a reduced order model (ROM) sensor system to determine aircraft sensor failure and correct aircraft sensor measurement in an aircraft system in accordance with one or more exemplary embodiments;
>
> FIG. 2 illustrates a flowchart of a method to determine aircraft sensor failure and correct aircraft sensor measurement in an aircraft system in accordance with one or more exemplary embodiments;
>
> FIG. 3 illustrates a bar graph plotting a comparison between a reduced order model (ROM) predicted ACM speed to a detailed high-fidelity model ACM speed in accordance with one or more exemplary embodiments; and
>
> FIG. 4 illustrates a scatter plot graph plotting a comparison between a reduced order model (ROM) predicted ACM speed to a detailed high-fidelity model ACM speed in accordance with one or more exemplary embodiments.

DETAILED DESCRIPTION

As shown and described herein, various features of the disclosure will be presented. Various embodiments may have the same or similar features and thus the same or similar features may be labeled with the same reference numeral, but preceded by a different first number indicating the figure to which the feature is shown. Thus, for example, element "a" that is shown in FIG. X may be labeled "Xa" and a similar feature in FIG. Z may be labeled "Za." Although similar reference numbers may be used in a generic sense, various embodiments will be described and various features may include changes, alterations, modifications, etc. as will be appreciated by those of skill in the art, whether explicitly described or otherwise would be appreciated by those of skill in the art.

Embodiments described herein are directed to creating a reduced order model (ROM) for an aircraft system that positively correlates with a sensor of interest to help detect when the sensor of interest drifts and/or fails entirely.

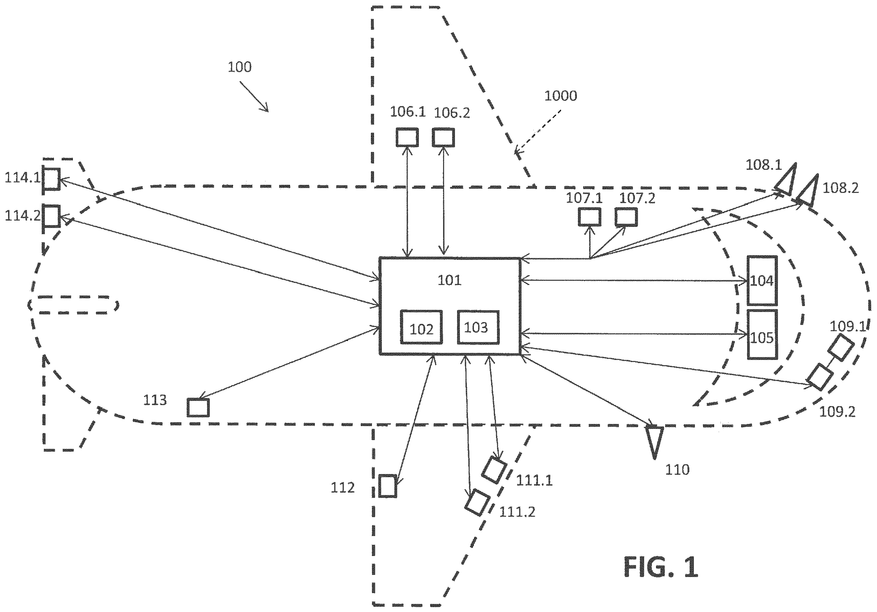

For example, turning now to FIG. 1, a reduced order model (ROM) sensor system 100 to determine aircraft sensor failure and correct aircraft sensor measurement in an aircraft system 1000 is shown in accordance with one or more embodiments.

According to one or more embodiments, the ROM sensor system 100 includes an aircraft system controller 101 that includes at least one processor 102 and computer readable storage medium 103. The aircraft system controller 101 is connected to a display 104 and an input device 105 that are located in the flight deck of the aircraft system 1000. The aircraft system controller 101 is also connected to a plurality of sensors. The plurality of sensors can be any known sensor type and have any known placement that can be provided in or on an aircraft system 1000.

For example, according to one or more exemplary embodiments, the plurality of sensors can be included within, but are not limited to, Cabin Air Condition systems, Air Data Products and Systems, Electronic flight bag (EFB) Solutions, Engines and Space Sensors, Guidance, Navigation and Control (GNC) sensors and systems, Health and Usage Management Systems (HUMS), Ice Detection and Protection Systems, In-flight Entertainment (IFE) systems, Fire Protection Systems, Mission Data Recorders, Rescue Hoists and Cargo Winch sensors and systems.

Further, according to one or more embodiments, the sensors can also be included as part of other systems such as Actuation Systems, Aerostructures, Air Management Systems, Electric Systems, Engine Components, Engine & Control Systems, Interiors, Intelligence, Surveillance and Reconnaissance (ISR) Systems, Landing Gear, Propeller Systems, Sensors & Integrated Systems, Space Systems, and Wheels & Brakes.

Looking back at FIG. 1 according to one or more embodiments, the sensors are provided in redundant and non-redundant fashion. For example, sensors 111.1, 111.2 are provided in redundant fashion. In contrast sensor 112 is provided alone. Sensor pairs can be provided at many different positions within the aircraft. For example a sensor pair 106.1, 106.2 are provided in a wing of the aircraft. Similarly sensor pair 114.1, 114.2 is provided in a rear stabilizer. A sensor can also be provided in singular fashion within the fuselage such as sensor 113. The sensors can also be connected to the aircraft system controller 101 in series, parallel, or a combination. For example, sensor pair 107.1, 107.2 is connected to the aircraft system controller 101 using a parallel connection. In contrast, sensor pair 109.1, 109.2 is connected to the aircraft system controller in a series arrangement. Further, sensors can also be placed on the exterior of the aircraft system 1000. For example, a pair of redundant sensors 108.1, 108.2 can be provided near the cockpit. In contrast a single sensor 110 can be placed along the outside surface of the fuselage. According to other embodiments, there may be other sensors provided at different locations in other arrangements. Further, the sensors could also be equipped with the ability to communicate with the aircraft system controller by wired and/or wireless communication channels.

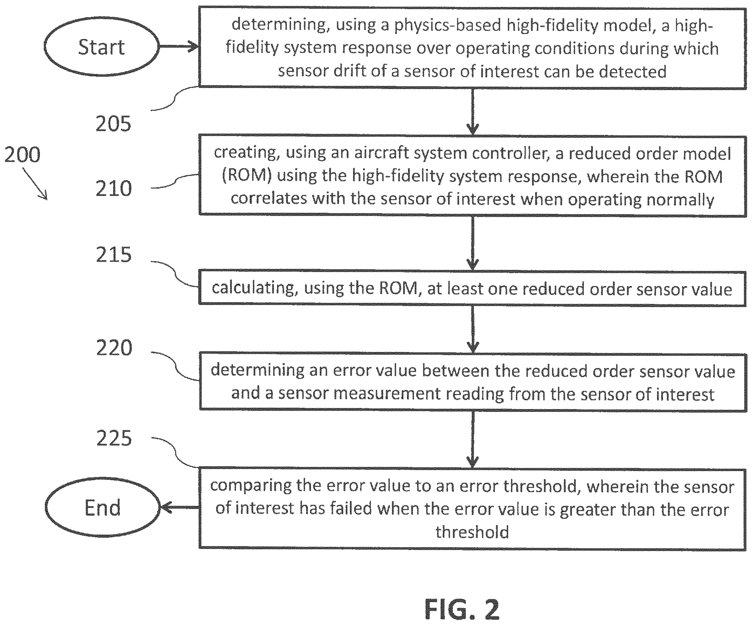

FIG. 2 illustrates a flowchart of a method 200 to determine aircraft sensor failure and correct aircraft sensor measurement in an aircraft system in accordance with one or more exemplary embodiments. The method 200 includes determining, using a physics-based high-fidelity model, a high-fidelity system response over operating conditions during which sensor drift of a sensor of interest can be detected (operation 205). The method 200 also includes creating, using an aircraft system controller, a reduced order model (ROM) using the high-fidelity system response, wherein the ROM correlates with the sensor of interest when operating normally (operation 210). Further, the method 200 includes calculating, using the ROM, at least one reduced order sensor value (operation 215). The method 200 also includes determining an error value between the reduced order sensor value and a sensor measurement reading from the sensor of interest (operation 220). Further, the method 200 includes comparing the error value to an error threshold, wherein the sensor of interest has failed when the error value is greater than the error threshold (operation 225).

According to another embodiment, the method 200 can further include generating a maintenance message based on the error value, storing the maintenance message in a computer readable storage medium in the aircraft system controller, and transmitting the maintenance message from the aircraft system controller. According to another embodiment, the method 200 can further include generating a notification based on the maintenance message, and transmitting the notification to a display visible at the flight deck by service crew. The notification identifies the sensor of interest and notifies that the sensor of interest has failed or drifted and provides a replacement recommendation.

According to another embodiment, the method 200 can further include generating, in the aircraft system controller, corrective control signals to protect the aircraft system based on the error value, and transmitting the corrective control signals to one or more components of the aircraft system.

According to another embodiment, the method 200 can further include, when creating the ROM, selecting, from a high-fidelity set of parameters, a sub-set of parameters with high correlation to the sensor of interest. The sub-set of parameters has corresponding sensors in the aircraft system such that measurements from the sensors can be used to generate the reduced order sensor value. According to another embodiment, the method 200 can further include, when creating the ROM, determining ROM regression coefficients of the ROM. According to another embodiment, the sub-set of parameters of the ROM include one or more of system pressures, system temperatures, valve positions, control references, characteristics related to ambient environment, and characteristics related to aircraft operation.

According to another embodiment, the method 200 can further include determining, using the ROM, a reduced order system response that comprises one or more reduced order sensor values, and determining an aggregate error response between the reduced order system response and a plurality of sensor measurement readings from the sensor of interest.

According to another embodiment, the method 200 can further include controlling the aircraft system using the calculated reduced order sensor value in response to the sensor of interest failing.

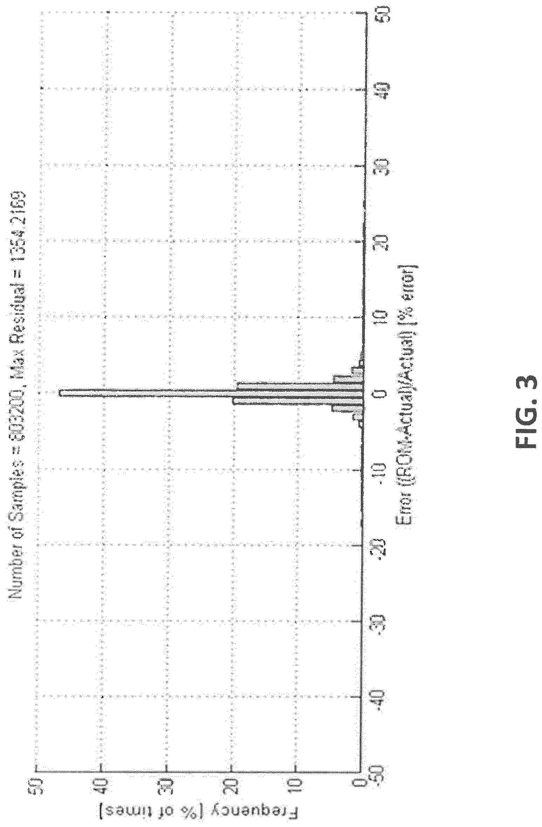

FIG. 3 illustrates a bar graph plotting a comparison between a reduced order model (ROM) predicted ACM speed to a detailed high-fidelity model ACM speed in accordance with one or more exemplary embodiments. Specifically, the graph plots error percent along the x-axis and the frequency, or percent of times, along the y-axis. Therefore, according to an embodiment as shown, over forty percent of the time there may be zero percent error. Further, as shown, less than twenty percent of the times there is about one percent error. Additionally, as shown, the values continue to drop off and quickly approach zero showing that the ROM predicted ACM speed can closely match, with little error, that which is provided by a high-fidelity model ACM speed.

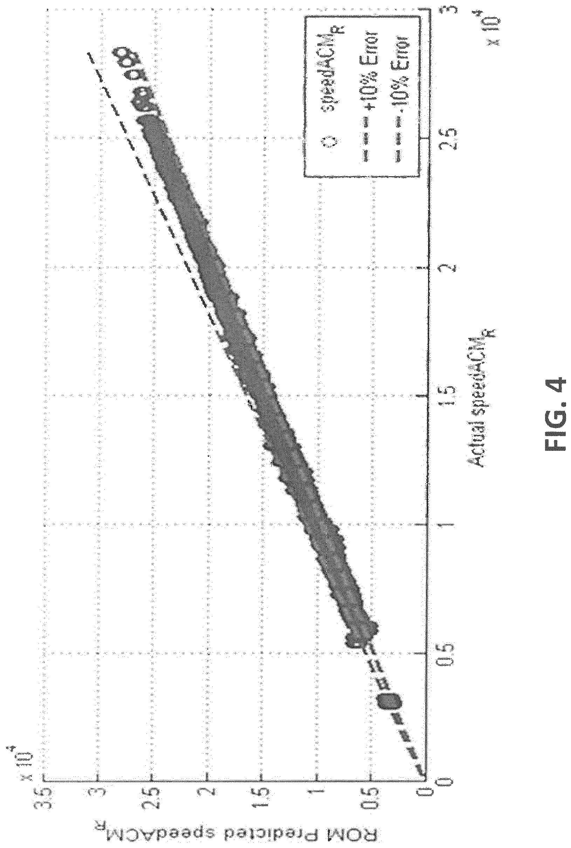

FIG. 4 illustrates a scatter plot graph plotting a comparison between a reduced order model (ROM) predicted ACM speed to a detailed high-fidelity model ACM speed in accordance with one or more exemplary embodiments. Results in FIG. 4 show that even when uncertainties are introduced, the ROM is robust enough to give reliable predictions with reasonable accuracies for predicted speed ACM values.

Further, according to one or more embodiments, some active protective controls that rely on sensor readings in aircraft air conditioning packs include high compressor discharge temperatures, high pack outlet temperatures, preventing freezing temperatures in the condenser, preventing freezing conditions from entering the turbines, preventing the air supply ducts from melting or water freezing in air supply ducts.

Some examples, according to one or more embodiments, of active protective controls that rely on accurate sensor readings on aircraft vapor cycle cooling systems include protection against high compressor discharge temperature, high compressor discharge pressure, compressor power, low compressor pressure ratio, and low compressor suction pressure.

Some examples, according to one or more embodiments, of active common protective controls on aircraft liquid cooling systems include protection against pump and other component over pressure and prevention of HX freezing.

According another embodiment, a method to determine aircraft sensor failure and correct aircraft sensor measurement in an aircraft system includes, using a physics-based high-fidelity model, a user meshing and determining the system response over the entire operating conditions of interest that the user wishes to detect sensor drift. With these results a Reduced Order Model (ROM) is created by methodically selecting the parameters that show high correlation to the sensor of interest. The parameters utilized by the ROM have corresponding sensors in the system such that the measurement is used as a part of the calculation. The parameters in the ROM include items such as system pressures, system temperatures, valve positions, control references, or characteristics related to the ambient environment or aircraft operation.

Further, according to an embodiment, ROM regression coefficients are determined. In an embodiment the ROM regression coefficients include nonlinear and interaction terms. According to another embodiment, the form of the ROM can take the form of the equation below:

$$y = b_0 + \sum_i b_i x_i^{c_i} + \sum_j b_j (X)_j^{c_j}$$

Where the $b_o$ is a constant, $b$ is the multiplicative regression coefficients, c is the exponential regression coefficients, x are first order parameters, and $X$ are the interaction terms (the product of any two first order parameters). Sensor variability/tolerance is included in analysis to ensure that the ROM is robust and not overly sensitive to sensor measurement inaccuracies and biases.

In an embodiment, the method then determines the error between the sensor measurement reading and the ROM calculated sensor value. If this error is greater than a specified tolerance, the sensor can be assumed failed. At this time, a maintenance message can be provided and the system can take corrective action to protect itself using designed backup controls since the system knows that the sensor reading is no longer correct.

Advantageously, embodiments described herein provide a method that can be used to generate notifications to the flight deck and/or service crew that the sensor needs to be replaced or repaired. By detecting and replacing a failed sensor early, potential damage to the hardware can be prevented. In addition, in the event of a failed non-redundant sensor, the control system may temporarily use the calculated value instead of the sensor reading for protective or backup controls to prevent any hardware damage. If there is a redundant sensor, system efficiency and performance can be improved compared to the existing state of using the more conservative reading because by using the ROM, one can diagnose and correctly use the sensor that is functioning correctly.

Redundant sensors are included to help mitigate the impact of misreading sensors. By using one of the proposed embodiments of the method disclosed herein, the number of redundant sensors may be reduced which will reduce cost and complexity to the product.

One or more embodiments of the method can be used to generate notifications to the flight deck and/or service crew that the sensor needs to be replaced. By replacing a sensor early, pack performance and pack efficiency can be improved in the event of a drifting sensor.

Redundant sensors are included to help mitigate the impact of misreading sensors. By using one of the proposed embodiments of the method, the number of redundant sensors may be reduced which will reduce cost and complexity to the product because the ROM can be used in lieu of a redundant sensor.

While the present disclosure has been described in detail in connection with only a limited number of embodiments, it should be readily understood that the present disclosure is not limited to such disclosed embodiments. Rather, the present disclosure can be modified to incorporate any number of variations, alterations, substitutions, combinations, sub-combinations, or equivalent arrangements not heretofore described, but which are commensurate with the scope of the present invention as defined by the claims. Additionally, while various embodiments of the present disclosure have been described, it is to be understood that aspects of the present disclosure may include only some of the described embodiments.

The terminology used herein is for the purpose of describing particular embodiments only and is not intended to be limiting. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or step plus function elements in the claims below are intended to include any structure, material, or act for performing the function in combination with other claimed elements as specifically claimed. The description has been presented for purposes of illustration and description, but is not intended to be exhaustive or limited to the embodiments in the form disclosed. Many modifications and variations will be apparent to those of ordinary skill in the art without departing from the scope of the claims. The embodiments were chosen and described in order to best explain the principles of the disclosure and the practical application, and to enable others of ordinary skill in the art to understand various embodiments with various modifications as are suited to the particular use contemplated.

The present embodiments may be a system, a method, and/or a computer program product at any possible technical detail level of integration. The computer program product may include a computer readable storage medium (or media) having computer readable program instructions thereon for causing a processor to carry out aspects of the present disclosure.

The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device.

Computer readable program instructions for carrying out operations of the present disclosure may be assembler instructions, instruction-set-architecture (ISA) instructions, machine instructions, machine dependent instructions, microcode, firmware instructions, state-setting data, configuration data for integrated circuitry, or either source code or object code written in any combination of one or more programming languages, including an object oriented programming language such as Java, Smalltalk, C++, or the like, and conventional procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present disclosure.

Aspects of the present invention are described herein with reference to flowchart illustrations and/or block diagrams of methods, apparatus (systems), and computer program products according to embodiments. It will be understood that each block of the flowchart illustrations and/or block diagrams, and combinations of blocks in the flowchart illustrations and/or block diagrams, can be implemented by computer readable program instructions.

These computer readable program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

The flowchart and block diagrams in the Figures illustrate the architecture, functionality, and operation of possible implementations of systems, methods, and computer program products according to various embodiments. In this regard, each block in the flowchart or block diagrams may represent a module, segment, or portion of instructions, which comprises one or more executable instructions for implementing the specified logical function(s). In some alternative implementations, the functions noted in the blocks may occur out of the order noted in the Figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

The descriptions of the various embodiments have been presented for purposes of illustration, but are not intended to be exhaustive or limited to the embodiments disclosed. Many modifications and variations will be apparent to those of ordinary skill in the art without departing from the scope of the claims. The terminology used herein was chosen to best explain the principles of the embodiments, the practical application or technical improvement over technologies found in the marketplace, or to enable others of ordinary skill in the art to understand the embodiments disclosed herein.

Accordingly, the present disclosure is not to be seen as limited by the foregoing description, but is only limited by the scope of the appended claims.

**Claims**

1. A computer implemented method to determine aircraft sensor failure and correct aircraft sensor measurement in an aircraft system, the computer implemented method being executed by a processor (102) of an aircraft system controller (101) and comprising:

   determining (205), using a physics-based high-fidelity model, a high-fidelity system response over selected operating conditions for a sensor of interest (106-114); the method **characterized by**

   creating (210), using an aircraft system controller (101), a reduced order model, ROM, using the high-fidelity system response, wherein the ROM correlates with the sensor of interest when operating normally;

   calculating (215), using the ROM, at least one reduced order sensor value;

   determining (220) an error value between the reduced order sensor value and a sensor measurement reading from the sensor of interest; and

   comparing (225) the error value to an error threshold, wherein the sensor of interest has failed when the error value is greater than the error threshold.

2. The computer implemented method of claim 1, further comprising:

   generating a maintenance message based on the error value;

   storing the maintenance message in a computer readable storage medium in the aircraft system controller (101); and

   transmitting the maintenance message from the aircraft system controller.

3. The computer implemented method of claim 2, further comprising:

   generating a notification based on the maintenance message; and

   transmitting the notification to a display (104) visible at the flight deck by service crew, wherein the notification identifies the sensor of interest and notifies that the sensor of interest has failed or drifted and provides a replacement recommendation.

4. The computer implemented method of claim 1, further comprising:

   generating, in the aircraft system controller, corrective control signals to protect the aircraft system based on the error value; and

   transmitting the corrective control signals to one or more components of the aircraft system.

5. The computer implemented method of claim 1, wherein creating the ROM comprises:

   selecting, from a high-fidelity set of parameters, a sub-set of parameters with high correlation to the sensor of interest,

   wherein the sub-set of parameters have corresponding sensors in the aircraft system such that measurements from the sensors are used to generate the reduced order sensor value.

6. The computer implemented method of claim 5, wherein creating the ROM further comprises:
   determining ROM regression coefficients of the ROM.

7.  The computer implemented method of claim 5, wherein the sub-set of parameters of the ROM include one or more of system pressures, system temperatures, valve positions, control references, characteristics related to ambient environment, and characteristics related to aircraft operation.

8.  The computer implemented method of claim 1, further comprising:

    determining, using the ROM, a reduced order system response that comprises one or more reduced order sensor values; and
    determining an aggregate error response between the reduced order system response and a plurality of sensor measurement readings from the sensor of interest.

9.  The computer implemented method of claim 1, further comprising:
    controlling the aircraft system using the calculated reduced order sensor value in response to the sensor of interest failing.

10. A reduced order model (ROM) sensor system to determine aircraft sensor failure and correct aircraft sensor measurement of an aircraft system, the ROM sensor system comprising:

    a plurality of sensors (106, 107, 108, 109, 110, 111, 112, 113, 114) that include a sensor of interest;
    a memory (103) having computer readable instructions; and
    an aircraft system controller (101) having a processor (102) configured to execute the computer readable instructions, the computer readable instructions comprising:

        determining (205), using a physics-based high-fidelity model, a high-fidelity system response over selected operating conditions for the sensor of interest; the system **characterized by** the computer readable instructions further comprising
        creating (210), using the aircraft system controller, a reduced order model (ROM) using the high-fidelity system response, wherein the ROM correlates with the sensor of interest when operating normally;
        calculating (215), using the ROM, at least one reduced order sensor value;
        determining (220) an error value between the reduced order sensor value and a sensor measurement reading from the sensor of interest; and

    comparing (225) the error value to an error threshold, wherein the sensor of interest has failed when the error value is greater than the error threshold.

11. The ROM sensor system of claim 10, further comprising additional computer readable instructions comprising:

    generating a maintenance message based on the error value;
    storing the maintenance message in a computer readable storage medium in the aircraft system controller; and
    transmitting the maintenance message from the aircraft system controller.

12. The ROM sensor system of claim 11, further comprising additional computer readable instructions comprising:

    generating a notification based on the maintenance message; and
    transmitting the notification to a display visible at the flight deck by service crew,
    wherein the notification identifies the sensor of interest and notifies that the sensor of interest has failed or drifted and provides a replacement recommendation.

13. The ROM sensor system of claim 10, further comprising additional computer readable instructions comprising:

    generating, in the aircraft system controller, corrective control signals to protect the aircraft system based on the error value; and
    transmitting the corrective control signals to one or more components of the aircraft system.

14. The ROM sensor system of claim 10, wherein creating the ROM comprises:

    selecting, from a high-fidelity set of parameters, a sub-set of parameters with high correlation to the sensor of interest,
    wherein the sub-set of parameters have corresponding sensors in the aircraft system such that measurements from the sensors are used to generate the reduced order sensor value.

15. The ROM sensor system of claim 14, wherein creating the ROM further comprises:
    determining the ROM regression coefficients.

**Patentansprüche**

1. Computerimplementiertes Verfahren zur Fehlerbestimmung in einem Flugzeugsensor sowie angepasste Flugzeugsensormessungen in einem Flugzeugsystem, wobei das computerimplementierte Verfahren durch einen Prozessor (102) einer Flugzeugsystemsteuerung (101) ausgeführt wird und Folgendes umfasst:

Bestimmen (205), unter Verwendung eines physikalisch fundierten, datengetreuen Models, einer datengetreuen Systemantwort bei ausgewählten Betriebsbedingungen für einen interessierenden Sensor (106-114); wobei das Verfahren **gekennzeichnet ist durch**
Erschaffen (210), unter Verwendung einer Flugzeugsystemsteuerung (101), eines reduzierten Ordnungsmodells (reduced order model - ROM), unter Verwendung der datengetreuen Systemantwort, wobei das ROM bei Normalbetrieb mit dem interessierenden Sensor korreliert;
Berechnen (215), unter Verwendung des ROM, mindestens eines reduzierten Ordnungssensorwerts;
Bestimmen (220) eines Abweichungswerts zwischen dem reduzierten Ordnungssensorwert und einer Auslesung von Sensormessungen aus dem interessierenden Sensor; und
Vergleichen (225) des Abweichungswerts mit einem Abweichungsschwellenwert, wobei der interessierende Sensor fehlerhaft ist, wenn der Abweichungswert größer als der Abweichungsschwellenwert ist.

2. Computerimplementiertes Verfahren nach Anspruch 1, ferner umfassend:

Erzeugen einer Wartungsnachricht auf Grundlage des Abweichungswerts;
Speichern der Wartungsnachricht in einem computerlesbaren Speichermedium in der Flugzeugsystemsteuerung (101); und
Übertragen der Wartungsnachricht von der Flugzeugsystemsteuerung.

3. Computerimplementiertes Verfahren nach Anspruch 2, ferner umfassend:

Erzeugen einer Mitteilung auf Grundlage der Wartungsnachricht; und
Übertragen der Mitteilung an eine Anzeige (104), die in dem Cockpit von einem Service-Team gesehen werden kann,
wobei die Mitteilung den interessierenden Sensor identifiziert und mitteilt, dass der interessierende Sensor fehlerhaft ist oder abweicht, und eine Ersatzempfehlung bereitstellt.

4. Computerimplementiertes Verfahren nach Anspruch 1, ferner umfassend:

Erzeugen, in der Flugzeugsystemsteuerung, eines Anpassungssteuersignals, um das Flugzeugsystem auf Grundlage des Abweichungswerts zu schützen; und
Übertragen des Anpassungssteuersignals an eine oder mehrere Komponenten des Flugzeugsystems.

5. Computerimplementiertes Verfahren nach Anspruch 1, wobei das Erschaffen des ROM Folgendes umfasst:

Auswählen, aus einem datengetreuen Satz von Parametern, eines Teilsatzes von Parametern mit einer hohen Korrelation mit dem interessierenden Sensor,
wobei der Teilsatz von Parametern entsprechende Sensoren in dem Flugzeugsystem aufweist, sodass Messungen von den Sensoren verwendet werden, um den reduzierten Ordnungssensorwert zu erzeugen.

6. Computerimplementiertes Verfahren nach Anspruch 5, wobei das Erschaffen des ROM ferner Folgendes umfasst: Bestimmen von ROM-Regressionskoeffizienten des ROM.

7. Computerimplementiertes Verfahren nach Anspruch 5, wobei der Teilsatz von Parametern des ROM eines oder mehrere von Systemdrücken, Systemtemperaturen, Ventilpositionen, Steuerreferenzen, Eigenschaften hinsichtlich einer Umgebung und Eigenschaften hinsichtlich des Flugzeugbetriebs beinhaltet.

8. Computerimplementiertes Verfahren nach Anspruch 1, ferner umfassend:

Bestimmen, unter Verwendung des ROM, einer reduzierten Ordnungssystemantwort, die einen oder mehrere Ordnungssensorwerte umfasst; und
Bestimmen einer Aggregatsabweichungsantwort zwischen der reduzierten Ordnungssystemantwort und einer Vielzahl von Auslesungen von Sensormessungen von dem interessierenden Sensor.

9. Computerimplementiertes Verfahren nach Anspruch 1, ferner umfassend:
Steuern des Flugzeugsystems unter Verwendung des berechneten reduzierten Ordnungssensorwerts als Reaktion darauf, dass der interessierende Sensor ausfällt.

**10.** Sensorsystem mit reduziertem Ordnungsmodell (reduced order model - ROM) zur Fehlerbestimmung in einem Flugzeugsensor und angepasste Sensormessungen eines Flugzeugsystems, wobei das ROM-Sensorsystem Folgendes umfasst:

    eine Vielzahl von Sensoren (106, 107, 108, 109, 110, 111, 112, 113, 114), die einen interessierenden Sensor beinhalten;
    einen Speicher (103), der computerlesbare Anweisungen aufweist; und
    eine Flugzeugsystemsteuerung (101), die einen Prozessor (102) aufweist, der dazu konfiguriert ist, die computerlesbaren Anweisungen auszuführen, wobei die computerlesbaren Anweisungen Folgendes umfassen:
    Bestimmen (205), unter Verwendung eines physikalisch fundierten, datengetreuen Models, einer datengetreuen Systemantwort bei ausgewählten Betriebsbedingungen für einen interessierenden Sensor; wobei das System **dadurch gekennzeichnet ist, dass** die computerlesbaren Anweisungen ferner Folgendes umfassen:

        Erschaffen (210), unter Verwendung einer Flugzeugsystemsteuerung (101), eines reduzierten Ordnungsmodells (reduced order model - ROM), unter Verwendung der datengetreuen Systemantwort, wobei das ROM bei Normalbetrieb mit dem interessierenden Sensor korreliert;
        Berechnen (215), unter Verwendung des ROM, mindestens eines reduzierten Ordnungssensorwerts;
        Bestimmen (220) eines Abweichungswerts zwischen dem reduzierten Ordnungssensorwert und einer Auslesung von Sensormessungen aus dem interessierenden Sensor; und
        Vergleichen (225) des Abweichungswerts mit einem Abweichungsschwellenwert, wobei der interessierende Sensor fehlerhaft ist, wenn der Abweichungswert größer als der Abweichungsschwellenwert ist.

**11.** ROM-Sensorsystem nach Anspruch 10, ferner umfassend zusätzliche computerlesbare Anweisungen, die Folgendes umfassen:

        Erzeugen einer Wartungsnachricht auf Grundlage des Abweichungswerts;
        Speichern der Wartungsnachricht in einem computerlesbaren Speichermedium in der Flugzeugsystemsteuerung; und
        Übertragen der Wartungsnachricht von der Flugzeugsystemsteuerung.

**12.** ROM-Sensorsystem nach Anspruch 11, ferner umfassend zusätzliche computerlesbare Anweisungen, die Folgendes umfassen:

        Erzeugen einer Mitteilung auf Grundlage der Wartungsnachricht; und
        Übertragen der Mitteilung an eine Anzeige, die in dem Cockpit von einem Service-Team gesehen werden kann,
        wobei die Mitteilung den interessierenden Sensor identifiziert und mitteilt, dass der interessierende Sensor fehlerhaft ist oder abweicht und eine Ersatzempfehlung bereitstellt.

**13.** ROM-Sensorsystem nach Anspruch 10, ferner umfassend zusätzliche computerlesbare Anweisungen, die Folgendes umfassen:

        Erzeugen, in der Flugzeugsystemsteuerung, von Anpassungssteuersignalen, um das Flugzeugsystem auf Grundlage des Abweichungswerts zu schützen; und
        Übertragen des Anpassungssteuersignals an eine oder mehrere Komponenten des Flugzeugsystems.

**14.** ROM-Sensorsystem nach Anspruch 10, wobei das Erschaffen des ROM Folgendes umfasst:

        Auswählen, aus einem datengetreuen Satz von Parametern, eines Teilsatzes von Parametern mit einer hohen Korrelation mit dem interessierenden Sensor,
        wobei der Teilsatz von Parametern entsprechende Sensoren in dem Flugzeugsystem aufweist, sodass Messungen von den Sensoren verwendet werden, um den reduzierten Ordnungssensorwert zu erzeugen.

**15.** ROM-Sensorsystem nach Anspruch 14, wobei das Erschaffen des ROM ferner Folgendes umfasst: Bestimmen der ROM-Regressionskoeffizienten.

## Revendications

**1.** Méthode mise en oeuvre par ordinateur pour déterminer une erreur de capteur dans un aéronef et corriger une mesure de capteur dans un aéronef dans un système d'aéronef, la méthode mise en oeuvre par ordinateur étant exécutée par un processeur (102) d'un dispositif de commande de système d'aéronef (101) et comprenant :

        la détermination (205), à l'aide d'un modèle haute fidélité basé sur la physique, d'une réponse de système haute fidélité sur des conditions de fonctionnement sélectionnées pour un capteur d'intérêt (106-114) ;

la méthode étant **caractérisée par**

la création (210), à l'aide d'un dispositif de commande de système d'aéronef (101), d'un modèle d'ordre réduit, ROM, à l'aide de la réponse de système haute fidélité, dans laquelle le ROM est en corrélation avec le capteur d'intérêt lorsqu'il fonctionne normalement ;

le calcul (215), à l'aide du ROM, d'au moins une valeur de capteur d'ordre réduit ;

la détermination (220) d'une valeur d'erreur entre la valeur de capteur d'ordre réduit et une lecture de mesure de capteur à partir du capteur d'intérêt ; et

la comparaison (225) de la valeur d'erreur avec un seuil d'erreur, dans laquelle le capteur d'intérêt indique une erreur lorsque la valeur d'erreur est supérieure au seuil d'erreur.

2. Méthode mise en oeuvre par ordinateur selon la revendication 1, comprenant en outre :

la génération d'un message de maintenance basé sur la valeur d'erreur ;

le stockage du message de maintenance sur un support de stockage lisible par ordinateur dans le dispositif de commande de système d'aéronef (101) ; et

la transmission du message de maintenance à partir du dispositif de commande de système d'aéronef.

3. Méthode mise en oeuvre par ordinateur selon la revendication 2, comprenant en outre :

la génération d'une notification basée sur le message de maintenance ; et

la transmission de la notification à un écran (104) visible au niveau du poste de pilotage par l'équipage de service,

dans laquelle la notification identifie le capteur d'intérêt et notifie que le capteur d'intérêt indique une erreur ou un écart et fournit une recommandation de remplacement.

4. Méthode mise en oeuvre par ordinateur selon la revendication 1, comprenant en outre :

la génération, dans le dispositif de commande de système d'aéronef, de signaux de commande correctifs pour protéger le système d'aéronef sur la base de la valeur d'erreur ; et

la transmission des signaux de commande correctifs à un ou plusieurs composants du système d'aéronef.

5. Méthode mise en oeuvre par ordinateur selon la revendication 1, dans laquelle la création du ROM comprend :

la sélection, à partir d'un ensemble de paramètres haute fidélité, d'un sous-ensemble de paramètres présentant une corrélation élevée avec le capteur d'intérêt,

dans laquelle le sous-ensemble de paramètres a des capteurs correspondants dans le système d'aéronef de sorte que des mesures à partir des capteurs sont utilisées pour générer la valeur de capteur d'ordre réduit.

6. Méthode mise en oeuvre par ordinateur selon la revendication 5, dans laquelle la création du ROM comprend en outre :
la détermination de coefficients de régression ROM du ROM.

7. Méthode mise en oeuvre par ordinateur selon la revendication 5, dans laquelle le sous-ensemble de paramètres du ROM comporte un ou plusieurs des éléments parmi des pressions de système, des températures de système, des positions de soupape, des références de commande, des caractéristiques liées à l'environnement ambiant et des caractéristiques liées au fonctionnement de l'aéronef.

8. Méthode mise en oeuvre par ordinateur selon la revendication 1, comprenant en outre :

la détermination, à l'aide du ROM, d'une réponse de système d'ordre réduit qui comprend une ou plusieurs valeurs de capteur d'ordre réduit ; et

la détermination d'une réponse d'erreur globale entre la réponse de système d'ordre réduit et une pluralité de lectures de mesure de capteur à partir du capteur d'intérêt.

9. Méthode mise en oeuvre par ordinateur selon la revendication 1, comprenant en outre :
la commande du système d'aéronef à l'aide de la valeur de capteur d'ordre réduit calculée en réponse à l'erreur du capteur d'intérêt.

10. Système de capteur de modèle d'ordre réduit (ROM) pour déterminer une erreur de capteur dans un aéronef et corriger une mesure de capteur dans un aéronef d'un système d'aéronef, le système de capteur ROM comprenant :

une pluralité de capteurs (106, 107, 108, 109, 110, 111, 112, 113, 114) qui comporte un capteur d'intérêt ;

une mémoire (103) ayant des instructions lisibles par ordinateur ; et

un dispositif de commande de système d'aéronef (101) ayant un processeur (102) configuré pour exécuter les instructions lisibles par ordinateur, les instructions lisibles par ordinateur comprenant :

la détermination (205), à l'aide d'un modèle haute fidélité basé sur la physique, d'une réponse de système haute fidélité sur des conditions de fonctionnement sélectionnées pour le capteur d'intérêt ; le système étant **caractérisé par** les instructions lisibles par ordinateur comprenant en outre la création (210), à l'aide du dispositif de commande de système d'aéronef, d'un modèle d'ordre réduit (ROM) à l'aide de la réponse de système haute fidélité, dans lequel le ROM est en corrélation avec le capteur d'intérêt lorsqu'il fonctionne normalement ;

le calcul (215), à l'aide du ROM, d'au moins une valeur de capteur d'ordre réduit ;

la détermination (220) d'une valeur d'erreur entre la valeur de capteur d'ordre réduit et une lecture de mesure de capteur à partir du capteur d'intérêt ; et

la comparaison (225) de la valeur d'erreur avec un seuil d'erreur, dans lequel le capteur d'intérêt indique une erreur lorsque la valeur d'erreur est supérieure au seuil d'erreur.

11. Système de capteur ROM selon la revendication 10, comprenant en outre des instructions lisibles par ordinateur supplémentaires comprenant :

la génération d'un message de maintenance basé sur la valeur d'erreur ;

le stockage du message de maintenance sur un support de stockage lisible par ordinateur dans le dispositif de commande de système d'aéronef ; et

la transmission du message de maintenance à partir du dispositif de commande de système d'aéronef.

12. Système de capteur ROM selon la revendication 11, comprenant en outre des instructions lisibles par ordinateur supplémentaires comprenant :

la génération d'une notification basée sur le message de maintenance ; et

la transmission de la notification à un écran visible au niveau du poste de pilotage par l'équipage de service,

dans lequel la notification identifie le capteur d'intérêt et notifie que le capteur d'intérêt indique une erreur ou un écart et fournit une recommandation de remplacement.

13. Système de capteur ROM selon la revendication 10, comprenant en outre des instructions lisibles par ordinateur supplémentaires comprenant :

la génération, dans le dispositif de commande de système d'aéronef, de signaux de commande correctifs pour protéger le système d'aéronef sur la base de la valeur d'erreur ; et

la transmission des signaux de commande correctifs à un ou plusieurs composants du système d'aéronef.

14. Système de capteur ROM selon la revendication 10, dans lequel la création du ROM comprend :

la sélection, à partir d'un ensemble de paramètres haute fidélité, d'un sous-ensemble de paramètres présentant une corrélation élevée avec le capteur d'intérêt,

dans lequel le sous-ensemble de paramètres a des capteurs correspondants dans le système d'aéronef de sorte que des mesures à partir des capteurs sont utilisées pour générer la valeur de capteur d'ordre réduit.

15. Système de capteur ROM selon la revendication 14, dans lequel la création du ROM comprend en outre : la détermination de coefficients de régression ROM.

FIG. 1

```
                           ┌──────────────────────────────────────────────┐
                           │ determining, using a physics-based high-fidelity model, a high- │
         ┌─────────┐       │ fidelity system response over operating conditions during which │
         │  Start  │──────▶│ sensor drift of a sensor of interest can be detected │
         └─────────┘       └──────────────────────────────────────────────┘
                                                   │
              205                                  │
                                                   ▼
  200                      ┌──────────────────────────────────────────────┐
    ↘                      │ creating, using an aircraft system controller, a reduced order model │
                           │ (ROM) using the high-fidelity system response, wherein the ROM │
              210          │ correlates with the sensor of interest when operating normally │
                           └──────────────────────────────────────────────┘
                                                   │
              215                                  │
                                                   ▼
                           ┌──────────────────────────────────────────────┐
                           │ calculating, using the ROM, at least one reduced order sensor value │
                           └──────────────────────────────────────────────┘
                                                   │
              220                                  │
                                                   ▼
                           ┌──────────────────────────────────────────────┐
                           │ determining an error value between the reduced order sensor value │
                           │ and a sensor measurement reading from the sensor of interest │
                           └──────────────────────────────────────────────┘
                                                   │
              225                                  │
                                                   ▼
                           ┌──────────────────────────────────────────────┐
         ┌─────────┐       │ comparing the error value to an error threshold, wherein the sensor │
         │   End   │◀──────│ of interest has failed when the error value is greater than the error │
         └─────────┘       │ threshold │
                           └──────────────────────────────────────────────┘
```

**FIG. 2**

FIG. 3

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2388672 A

- US 20150322789 A

**Non-patent literature cited in the description**

- Data-driven model reduction and fault diagnosis for an aero gas turbine engine. **LU YUNJIA et al.** 2014 9TH IEEE CONFERENCE ON INDUSTRIAL ELECTRONICS AND APPLICATIONS. IEEE, 09 June 2014, 1936-1941